# EUROPÄISCHE PATENTSCHRIFT

(11) **EP 3 245 676 B1**
(45) Veröffentlichungstag und Bekanntmachung des Hinweises auf die Patenterteilung: **13.06.2018**
(21) Anmeldenummer: 17709340.8
(22) Anmeldetag: 10.02.2017
(51) Int. Cl.: H02N 2/06

(54) **VERFAHREN UND VORRICHTUNG ZUR ANSTEUERUNG EINES ELEKTROMECHANISCHEN ELEMENTS**
METHOD AND APPARATUS FOR CONTROLLING AN ELECTROMECHANICAL ELEMENT
PROCÉDÉ ET APPAREIL DE COMMANDE D'UN ÉLÉMENT ÉLECTROMÉCANIQUE

(30) Priorität: 11.02.2016 DE 102016102367; 11.05.2016 DE 102016108747
(43) Veröffentlichungstag der Anmeldung: 22.11.2017
(73) Patentinhaber: Physik Instrumente (PI) GmbH & Co. KG, 76228 Karlsruhe (DE)
(72) Erfinder: REITH, Jeremias, 76879 Hochstadt (DE)
(74) Vertreter: Schatt, Markus F.
(86) Internationale Anmeldenummer: PCT/DE2017/100105
(87) Internationale Veröffentlichungsnummer: WO 2017/137044

(56) Entgegenhaltungen:
- DE-A1-102011 108 175
- US-A1- 2010 241 274

## Beschreibung

Die Erfindung betrifft ein Verfahren zur Ansteuerung eines elektromechanischen Elements, insbesondere eines piezoelektrischen Aktors oder Piezoaktors, und eine entsprechende Vorrichtung zur Durchführen eines solchen Verfahrens.

Ein Verfahren zur Ansteuerung eines elektromechanischen Elements ist aus der US 2010/241274 A1 bekannt. Aus der DE 10 2011 108175 A1 ist eine Vorrichtung zur Ansteuerung eines elektromechanischen Elements bekannt. Weiterhin ist aus dem allgemeinen Stand der Technik ein Verfahren zur Ansteuerung eines Piezoaktors für einen Antrieb bekannt, bei welchem dieser über einen Treiber mit einer elektrischen Spannung in Form eines Sägezahns oder einer Rampe mit einer flacheren Flanke und einer steileren Flanke beaufschlagt wird, wobei der Aktor in der Phase der langsameren Spannungsänderung, d.h. im Bereich der flacheren Flanke, welche auch Stick-Phase genannt wird, eine entsprechend langsamere Ausdehnung oder Kontraktion vollführt, und ein mit dem Aktor in Friktionskontakt befindliches anzutreibendes Element dieser langsameren Bewegung aufgrund von Haftreibung folgen kann und folglich eine Antriebsbewegung bzw. ein Antriebsschritt resultiert, während in der Phase der schnellen Spannungsänderung, d.h. im Bereich der steileren Flanke, welche auch Slip-Phase genannt wird, der Aktor eine wesentlich schnellere Ausdehnung oder Kontraktion vollführt, welche so schnell ist, dass aufgrund der Trägheit des anzutreibenden Elements dieses der Bewegung des Aktors nicht mehr folgen kann, so dass aufgrund von Gleitreibung eine Relativbewegung zwischen dem Piezoaktor und dem anzutreibenden Element stattfindet und im Wesentlichen keine Antriebsbewegung resultiert.

Zur Realisierung eines entsprechenden Einzelschrittes des anzutreibenden Elements findet entweder zuerst eine Stick-Phase mit einer Ausdehnung des Aktors statt, wobei die Ausdehnung im Wesentlichen in Antriebsrichtung des anzutreibenden Elements erfolgt, mit einer sich anschließenden Slip-Phase mit einer Kontraktion des Aktors, wobei die Kontraktion im Wesentlichen entgegengesetzt zu der Antriebsrichtung erfolgt, oder aber es findet zuerst eine Slip-Phase mit einer Ausdehnung des Aktors im Wesentlichen entgegengesetzt zur Antriebsrichtung statt, gefolgt von einer Stick-Phase mit einer Kontraktion des Aktors im Wesentlichen in Antriebsrichtung. Durch Wahl der entsprechenden Abfolge von Stick- und Slip-Phase kann somit die Antriebsrichtung variiert werden.

Mittels Wiederholung kann eine Abfolge von Einzelschritten mit einer jeweiligen Schrittweite - je nach mechanischer Auslegung des Antriebs -von typischerweise etwa 100 - 600nm generiert werden, wodurch eine quasikontinuierliche Bewegung ermöglicht ist. Entsprechende Antriebe werden auch als Stick-Slip-Antriebe oder Trägheitsantriebe bezeichnet.

Der vorstehend beschriebene Ansteuermodus bzw. der daraus resultierende Antriebsmodus wird auch als Schrittmodus bezeichnet, wobei sich dieser noch in einen kontinuierlichen und einen diskontinuierlichen Schrittmodus bzw. Einzelschrittmodus unterteilen lässt.

Solange die von einem mit dem Treiber elektrisch verbundenen Regler mit Hilfe eines Positionssensors überwachte Differenz zwischen Ist-Position und Soll-Position relativ groß und oberhalb eines definierten Wertes und außerhalb eines entsprechenden ersten Wertefensters um die Zielposition herum liegt, erfolgt eine Ansteuerung des Piezoaktors derart, dass eine hohe, insbesondere die höchstmögliche Bewegungsgeschwindigkeit des anzutreibenden Elements mit einer maximalen Anzahl von Einzelschritten pro Zeiteinheit resultiert, woraus eine relativ grobe und ungenaue Positionierung erfolgt (Grobpositionierung). Dazu werden von dem Regler getriggerte und von dem Treiber entsprechend generierte identische rampenförmige Spannungssignale mit einer sehr hohen Frequenz und ohne zeitliche Unterbrechung zwischen aufeinanderfolgenden Rampen der Spannung an den Piazoaktor ausgegeben (kontinuierlicher Schrittmodus).

Sobald der Regler mit Hilfe des Positionssensors erkennt, dass die Differenz zwischen der Ist-Position und der Soll-Position des anzutreibenden Elements klein und innerhalb des zuvor erwähnten ersten Wertefensters liegt, veranlasst der Regler ein Umschalten auf den diskontinuierlichen Schrittmodus oder Einzelschrittmodus, bei welchem zwischen aufeinanderfolgenden rampenförmigen Spannungssignalen, welche eine identische Form aufweisen und deren Form ebenso identisch zu den rampenförmigen Spannungssignalen während des kontinuierlichen Schrittmodus' ist, jeweils ein definierter zeitlicher Abstand besteht. Dieser zeitliche Abstand zwischen aufeinanderfolgenden rampenförmigen Spannungssignalen ist beabsichtigt, um den mechanischen Komponenten, die durch die Antriebsbewegung des Piezoaktors innerhalb eines Schrittes zu Schwingungen angeregt werden, ein Ausschwingen zu ermöglichen, so dass vor Durchführung eines etwaigen nachfolgenden Schritts mit hoher und verlässlicher Genauigkeit geprüft werden kann, ob die Differenz zwischen der Ist-Position und der Soll-Position des anzutreibenden Elements innerhalb eines zweiten Wertefenster liegt, so dass gegenüber der Grobpositionierung eine wesentlich genauere Positionierung resultiert. Dieses zweite Wertefenster wird definiert durch die maximal mögliche Deformation bzw. durch den Hub des Aktors, welcher typischerweise kleiner als 1 µm ist.

Ist demnach die Differenz zwischen der Ist-Position und der Soll-Position des anzutreibenden Elements gleich oder kleiner dem maximalen Hub des Piezoaktors, erfolgt durch den Regler ein erneutes Umschalten des Modus', so dass der Antrieb in den sogenannten Analogmodus wechselt, wobei in besagtem Analogmodus der Piezoaktor eine zur angelegten elektrischen Spannung analoge Deformation mit einer sehr hohen Auflösung ausübt, so dass eine hochgenaue Positionierung des anzutreibenden Elements realisierbar ist. Dabei gibt der Regler eine analoge Spannung vor, um die Position des anzutreibenden Elements zu regeln.

Nachteilig bei dem zuvor beschriebenen Verfahren nach dem Stand der Technik ist einerseits die Tatsache, dass dem Regler eine Vielzahl an Kriterien bereitgestellt werden muss, auf deren Grundlage dieser entsprechende Signale an den Treiber übergibt und insbesondere einen Wechsel des jeweiligen Modus' veranlasst. Diese Kriterien umfassen neben der Differenz zwischen der Ist-Position und der Soll-Position des anzutreibenden Elements u.a. die Schrittweite eines Einzelschrittes, die Zeit des Ausschwingens der mechanischen Komponenten des Antriebs und den Zeitpunkt zum Auslösen der steileren Flanke des rampen- bzw. sägezahnförmigen Spannungspulses. Dies verkompliziert die Realisierung eines entsprechenden Reglers. Das Umschalten zwischen den Modi entspricht dabei jeweils einer Unstetigkeitsstelle, die zu einer entsprechenden und nachteiligen Unstetigkeitsstelle im Ansteuersignal führt. Schließlich benötigt das aus dem Stand der Technik bekannte Verfahren sowohl zur Überprüfung, ob ein Umschalten zu einem anderen Modus notwendig ist, als auch zum jeweiligen Ausschwingen des mechanischen Anteils des Antriebs im diskontinuierlichen Schrittmodus eine gewisse Zeit, so dass sich insgesamt ein vergleichsweise langsames Ansteuerverfahren ergibt.

Der Erfindung liegt somit die Aufgabe zugrunde, ein Verfahren zur Ansteuerung eines elektromechanischen Elements anzugeben, welches die Nachteile des bekannten Verfahrens überwindet. Insbesondere ist es Aufgabe der Erfindung, ein Verfahren zur Ansteuerung eines elektromechanischen Elements bereitzustellen, bei welchem der Regler einfach realisiert werden kann und bei welchem ein mehrfaches Wechseln zwischen verschiedenen Modi vermieden werden kann, so dass ein schnelles und dennoch hochpräzises Ansteuerverfahren resultiert.

Diese Aufgabe wird gelöst durch ein Verfahren nach Anspruch 1 und eine Vorrichtung nach Anspruch 6, wobei die sich daran anschließenden Unteransprüche mindestens zweckmäßige Weiterbildungen darstellen.

Demnach wird von einem Ansteuerungsverfahren für ein elektromechanisches Element, insbesondere für einen piezoelektrischen Aktor bzw. einen Piezoaktor, zur Positionierung eines zumindest zeitweise mit dem elektromechanischen Element in Kontakt bzw. Reibkontakt stehenden anzutreibenden Elements ausgegangen, bei welchem in einem Schrittmodus an dem elektromechanischen Element elektrische Spannungspulse bzw. Spannungssignale anliegen. Jeder Spannungspuls weist hierbei wenigstens zwei Zeitabschnitte auf, wobei in einem der Zeitabschnitte eine durchschnittlich langsamere zeitliche Änderung der elektrischen Spannung und in dem anderen Zeitabschnitt eine durchschnittlich schnellere zeitliche Änderung der elektrischen Spannung stattfindet. Die zumindest zwei Zeitabschnitte können beispielsweise durch eine Unstetigkeitsstelle im zeitlichen Verlauf des Spannungssignals getrennt sein. Mit anderen Worten kann der Kurvenverlauf des sich zeitlich ändernden Spannungssignals eine Unstetigkeitsstelle aufweisen.

Der vorstehende Begriff 'durchschnittlich' in Verbindung mit den Begriffen 'langsamere zeitliche Änderung' und 'schnellere zeitliche Änderung' bezieht sich auf die durchschnittliche Neigung oder Steigung des Spannungspulssignalverlaufs über der Zeit in dem jeweiligen Abschnitt. Somit besitzt der Spannungspulssignalverlauf über der Zeit in einem seiner wenigstens zwei Zeitabschnitte eine größere oder kleinere durchschnittliche Steigung oder Neigung als in dem entsprechend anderen Zeitabschnitt. Denn es ist denkbar, dass der Spannungssignalverlauf über der Zeit in den beiden Zeitabschnitten keine konstante Steigung oder Neigung aufweist, sondern die Steigung bzw. Neigung dort bereichsweise variiert. Hierbei ist weiterhin denkbar, dass die einzelnen Bereiche konstante und/oder zeitlich veränderliche Werte der Steigung oder Neigung aufweisen.

Zumindest in einem Teil des Zeitabschnitts der durchschnittlich langsameren zeitlichen Änderung der elektrischen Spannung, welcher einen Antriebszeitabschnitt definiert, wird durch Haftreibung zwischen dem sich im Wesentlichen in Antriebsrichtung des anzutreibenden Elements expandierenden oder kontrahierenden elektromechanischen Elements und dem anzutreibenden Element dieses von dem elektromechanischen Element mitbewegt, und zumindest in einem Teil des Zeitabschnitts der durchschnittlich schnelleren zeitlichen Änderung der elektrischen Spannung, welcher einen Relativbewegungszeitabschnitt definiert, durch Gleitreibung zwischen dem sich im Wesentlichen entgegengesetzt zur Antriebsrichtung kontrahierenden oder expandierenden elektromechanischen Element und dem anzutreibenden Element eine Relativbewegung zwischen elektromechanischem Element und anzutreibendem Element stattfindet.

Der vorstehende Begriff ,im Wesentlichen' in Verbindung mit den Begriffen ,in Antriebsrichtung' und 'entgegengesetzt zur Antriebsrichtung' bedeutet, dass die Abweichung der Expansions- oder Kontraktionsrichtung von der Antriebsrichtung des anzutreibenden Elements bzw. von der dazu entgegengesetzten Richtung nur geringfügig und maximal um 5° abweicht.

Innerhalb des Antriebszeitabschnitts findet in entsprechender Weise eine langsamere Deformation des elektromechanischen Elements als innerhalb des Relativbewegungszeitabschnitts statt. Daher wird innerhalb des Antriebszeitabschnitts mit einer vergleichsweise langsamen Deformation des elektromechanischen Elements aufgrund der dann existierenden Haftreibung zwischen dem elektromechanischen Element und dem anzutreibenden Element dieses von dem elektromechanischen Element in Antriebsrichtung mitbewegt (Stick-Phase). Innerhalb des Relativbewegungszeitabschnitts mit einer vergleichsweise schnellen Deformation des Aktors in einer zur Deformationsrichtung innerhalb des Antriebszeitabschnitts im Wesentlichen entgegengesetzten Richtung kommt es aufgrund der Trägheit des anzutreibenden Elements zu einer Gleitreibung zwischen dem elektromechanischen Element und dem anzutreibenden Element, so dass eine Relativbewegung zwischen elektromechanischem Element und anzutreibendem Element stattfindet (Slip-Phase). In der Slip-Phase findet daher keine oder nur eine vernachlässigbare Bewegung des anzutreibenden Elements statt.

Durch zeitliche Abfolge bzw. durch das Nacheinanderausführen einer Stick-Phase und einer Slip-Phase führt das anzutreibende Element einen diskreten Antriebsschritt in einer ersten Antriebsrichtung aus, während durch zeitliche Abfolge bzw. Nacheinanderausführung einer Slip-Phase und einer Stick-Phase das anzutreibende Element einen diskreten Antriebschritt in einer zweiten und zur ersten Antriebsrichtung entgegengesetzten Antriebsrichtung ausführt. Durch entsprechende Wiederholung kann eine Vielzahl von diskreten Antriebsschritten und damit ein großer Verfahrweg realisiert werden, der prinzipiell nur durch die Ausdehnung bzw. Länge des anzutreibenden Elements begrenzt ist.

Das erfinderische Verfahren umfasst weiterhin das Vorsehen eines Reglers und eines damit elektrisch verbundenen Treibers.

Erfindungswesentlich ist, dass der Regler einen zeitkontinuierlichen Strom an den Treiber übergibt, und der Treiber einen korrespondierenden Ladestrom an das mit diesem elektrisch verbundene elektromechanische Element ausgibt, wobei der Regler den zeitkontinuierlichen Strom abhängig von der Differenz zwischen der Ist-Position und der Zielposition des anzutreibenden Elements stetig bzw. kontinuierlich anpasst, und der Treiber unabhängig vom Regler und alleine abhängig von der am elektromechanischen Element anliegenden Spannung eine elektrische Trennung des Treibers von dem Regler vornimmt.

Bei großer Differenz zwischen der Ist-Position und der Soll-Position ist der Wert des von dem Regler an den Treiber übergebenen Stromsignals hoch, und in analoger Weise ist der von dem Treiber an das elektromechanische Element ausgegebene Ladestrom ebenfalls hoch, so dass innerhalb eines vergleichsweise kurzen Zeitraums das elektromechanische Element mit einer definierten elektrischen Ladung bzw. mit einer definierten elektrischen Spannung beaufschlagt wird. Der Treiber überwacht hierbei die auf das elektromechanische Element aufgebrachte elektrische Ladung bzw. die entsprechend aufgebrachte elektrische Spannung. Sobald die elektrische Ladung bzw. die elektrische Spannung an dem elektromechanischen Element einen vorgegebenen definierten Wert erreicht oder überschritten hat, nimmt der Treiber selbständig und unabhängig vom Regler eine elektrische Trennung zwischen dem Treiber und dem Regler vor. Die Trennung erfolgt jedoch nur für einen kurzen Zeitraum, welcher deutlich kürzer als der vorhergehende Zeitraum ist, in welchem die elektrische Ladung auf das elektromechanische Element aufgebracht wurde.

Durch besagte elektrische Trennung zwischen dem Treiber und dem Regler kommt es in entsprechender Weise zu einer kurzfristigen Unterbrechung des an dem elektromechanischen Element anliegenden Stromsignals, so dass die zuvor auf dieses aufgebrachten elektrischen Ladungen abfließen können. Nach der kurzzeitigen Unterbrechung des Stromflusses zwischen dem Treiber und dem elektromechanischen Element erfolgt wieder eine elektrische Verbindung zwischen dem Treiber und dem Regler, so dass das elektromechanische Element erneut mit einer definierten elektrischen Ladung bzw. einer definierten elektrischen Spannung beaufschlagt wird.

Da der Zeitraum des Aufbringens elektrischer Ladungen auf das elektromechanische Element größer ist als der Zeitraum, in welchem die zuvor aufgebrachten elektrischen Ladungen wieder abfließen, und somit das Aufladen langsamer erfolgt als das Entladen, entspricht der Aufladungsvorgang dem Antriebszeitabschnitt, und der Entladungsvorgang dem Relativbewegungszeitabschnitt. Die elektrische Trennung zwischen dem Treiber und dem Regler entspricht somit einem Umschalten vom Antriebszeitabschnitt zum Relativbewegungszeitabschnitt.

Es sei an dieser Stelle betont, dass sich der zeitliche Verlauf der an dem elektromechanischen Element anliegenden elektrischen Spannung aufgrund des vom Treiber übergebenen Ladestroms keiner vorgegebenen Funktion folgt, sondern sich automatisch bzw. selbständig einstellt und definiert ist durch die anliegende Stromstärke und den Zeitpunkt bzw. der Dauer des Unterbrechens der elektrischen Verbindung zwischen dem Treiber und dem Regler. In erster Linie ergibt sich hierbei ein rampen- oder sägezahnähnlicher Verlauf der an dem elektromechanischen Element anliegenden Spannungspulse. Die Frequenz dieser Spannungspulse ergibt sich ebenfalls automatisch aus der Stromstärke und dem Zeitpunkt bzw. der Dauer des Unterbrechens der elektrischen Verbindung zwischen dem Treiber und dem Regler. Eine aktive Regelung der Frequenz und/oder des Verlaufs der an dem elektromechanischen Element anliegenden Spannung über der Zeit ist daher nicht notwendig.

Aus dem Vorstehenden folgt, dass dem Regler lediglich die Aufgabe zufällt, einen zeitkonstanten Strom in Abhängigkeit der Differenz zwischen der Ist-Position und der Zielposition des anzutreibenden Elements zu regeln. Der Regler muss also nur noch eine Regelgröße, nämlich den Strom, berücksichtigen. Wie bereits zuvor erwähnt, muss der Regler selbst keine spezifische Form eines Spannungsverlaufs über der Zeit oder eine Frequenz von Spannungspulsen vorgeben. Die Regelung eines zeitkonstanten Stroms hat den weiteren Vorteil, dass in gleichen Zeitabschnitten jeweils die gleiche elektrische Ladungsmenge auf das elektromechanische Element aufgebracht wird und dadurch eine Bewegung des elektromechanischen Elements mit einer höheren Linearität realisierbar ist.

Vorteilhaft ist zudem, dass der Regler völlig unbeeinflusst bleibt von dem Vorgang des Umschaltens vom Antriebszeitabschnitt zum Relativbewegungszeitabschnitt, da dies vollkommen unabhängig von dem Regler und selbständig durch den Treiber erfolgt. Dadurch wird eine Entlastung des Reglers realisiert, denn dieser muss nicht den Zeitpunkt zum Auslösen der steileren Flanke vorgeben.

Durch wiederholte Abfolge des zuvor beschriebenen langsameren Aufladungsvorgangs und des sich jeweils anschließenden schnelleren Vorgangs des Entladens, d.h. durch wiederholte Abfolge von Antriebszeitabschnitt und Relativbewegungszeitabschnitt, ergibt sich aufgrund des bei Vorliegens einer großen Differenz zwischen Ist-Position und Zielposition hohen Ladestroms, der dem elektromechanischen Element zugeführt wird, eine hohe, insbesondere eine maximale Antriebsgeschwindigkeit des anzutreibenden Elements, da - wie vorstehend ausgeführt - das elektromechanische Element in vergleichsweise kurzer Zeit mit einer definierten Ladungsmenge beaufschlagt wird, und der Antriebszeitabschnitt mit entsprechend hoher Frequenz (Antriebsfrequenz) wiederholt werden kann. Hierbei sei erwähnt, dass sich die Antriebszeitabschnitte jeweils ohne Pause an die Relativbewegungsabschnitte anschließen.

Mit stetig geringer werdender Differenz zwischen der Ist-Position und der Zielposition des anzutreibenden Elements erfolgt eine stetige Anpassung bzw. Reduktion des von dem Regler an den Treiber übergebenen elektrischen Stroms, so dass weiterhin in kontinuierlicher Weise, d.h. ohne zeitlichen Abstand zwischen nachfolgenden Antriebs- und Relativbewegungsabschnitten, Spannungspulse an dem elektromechanischen Element anliegen, wobei jedoch aufgrund der stetigen Anpassung des Stromwertes bedingt durch die sich stetig ändernde Differenz zwischen Ist-Position und Ziel-Position des anzutreibenden Elements der jeweilige Zeitabschnitt mit einer durchschnittlich langsameren zeitlichen Änderung der an dem elektromechanischen Element anliegenden elektrischen Spannung eine immer größer werdende Dauer aufweist, während der Zeitabschnitt mit einer durchschnittlich schnelleren zeitlichen Änderung der an dem elektromechanischen Element anliegenden elektrischen Spannung im Wesentlichen unverändert bleibt.

Durch die nun größere Dauer des Antriebszeitabschnitts bei etwa gleichbleibender Dauer des Relativbewegungsabschnitts nimmt die Antriebsfrequenz ab. Diese Antriebsfrequenzabnahme erfolgt in analoger Weise kontinuierlich und in Abhängigkeit von der abnehmenden Differenz zwischen der Ist-Position und der Zielposition des anzutreibenden Elements.

Im günstigsten Fall wird bereits alleine durch die zuvor beschriebene Art der Ansteuerung, d.h. alleine im Schrittmodus, die Zielposition des anzutreibenden Elements mit der gewünschten Genauigkeit erreicht, so dass ein Umschalten auf einen Analogmodus, bei welchem das elektromechanische Element eine zur angelegten elektrischen Spannung analoge Deformation mit einer sehr hohen Auflösung ausübt, komplett entfallen kann, was die Regelung abermals vereinfacht und schneller macht.

Es kann jedoch von Vorteil sein, dass sich an den Schrittmodus ein Analogmodus anschließt, bei welchem das elektromechanische Element mit einer zeitveränderlichen stetigen elektrischen Spannung beaufschlagt wird, so dass das elektromechanische Element dem Spannungssignal linear folgt und das anzutreibende Element eine entsprechende kontinuierliche und analoge Bewegung ausführt. Hierdurch kann im Einzelfall eine noch höhere Genauigkeit bei der Positionierung des anzutreibenden Elements erzielt werden.

Weiterhin kann es von Vorteil sein, dass der Regler dem Treiber ein digitales Signal übergibt, welches bestimmt, ob in dem Zeitabschnitt des elektrischen Spannungspulses mit einer durchschnittlich langsameren zeitlichen Änderung der elektrischen Spannung der Betrag der elektrischen Spannung zunimmt oder abnimmt. Hierdurch wird die Antriebsrichtung für das anzutreibende Element festgelegt.

Zudem kann es von Vorteil sein, dass der vom Regler an den Treiber übergebene zeitkontinuierliche Strom dergestalt ist, dass die Geschwindigkeit des anzutreibenden Elements zwischen dessen Ist-Position und dessen Zielposition einem definierten Profil folgt. Hierbei ist insbesondere ein S-förmiges Profil von Bedeutung, bei welchem die Geschwindigkeit des anzutreibenden Elements zu Beginn des entsprechenden Positioniervorgangs sehr langsam ist, dann stetig zunimmt bis zur maximal möglichen Geschwindigkeit und vor Erreichen der Zielposition bis zu dieser hin die Geschwindigkeit stetig reduziert wird.

Ferner betrifft die Erfindung eine Vorrichtung zur elektrischen Ansteuerung eines elektromechanischen Elements zur Positionierung eines zumindest zeitweise mit dem elektromechanischen Element in Kontakt stehenden anzutreibenden Elements, wobei die Vorrichtung eingerichtet ist, um in einem Schrittmodus das elektromechanische Element mit direkt aufeinanderfolgenden elektrischen Spannungspulsen zu beaufschlagen, wobei jeder Spannungspuls wenigstens zwei Zeitabschnitte aufweist, und in einem der Zeitabschnitte durchschnittlich eine langsamere zeitliche Änderung der elektrischen Spannung und in dem anderen Zeitabschnitt durchschnittlich eine schnellere zeitliche Änderung der elektrischen Spannung stattfindet, und zumindest in einem Teil des Zeitabschnitts der durchschnittlich langsameren zeitlichen Änderung der elektrischen Spannung, welcher einen Antriebszeitabschnitt definiert, durch Haftreibung zwischen dem sich in Antriebsrichtung expandierenden oder kontrahierenden elektromechanischen Element und dem anzutreibenden Element dieses von dem elektromechanischen Element mitbewegt wird, und zumindest in einem Teil des Zeitabschnitts der durchschnittlich schnelleren zeitlichen Änderung der elektrischen Spannung, welcher einen Relativbewegungszeitabschnitt definiert, durch Gleitreibung zwischen dem sich entgegengesetzt zur Antriebsrichtung kontrahierenden oder expandierenden elektromechanischen Element und dem anzutreibenden Element eine Relativbewegung zwischen elektromechanischem Element und anzutreibendem Element stattfindet, so dass das anzutreibende Element mit jedem Spannungspuls einen diskreten Schritt in Antriebsrichtung ausführt, und die Vorrichtung einen Regler und einen damit elektrisch verbundenen Treiber umfasst, wobei der Regler über eine Treiberschnittstelle einen zeitkontinuierlichen Strom an den Treiber übergibt und der Treiber einen entsprechenden Ladestrom an das mit diesem elektrisch verbundene elektromechanische Element ausgibt, und der Regler dazu eingerichtet ist, abhängig von der Differenz zwischen der Ist-Position und der Zielposition des anzutreibenden Elements den zeitkontinuierlichen Strom anzupassen, und der Treiber dazu eingerichtet ist, unabhängig vom Regler und abhängig von der am elektromechanischen Element anliegenden Spannung eine elektrische Trennung des Treibers von dem Regler vorzunehmen.

Hierbei kann es von Vorteil sein, dass der Treiber einen Stromtreiber, einen ersten Schalter, einen zweiten Schalter und einen Komparator aufweist, wobei der Ausgang des Stromtreibers mit einem Eingang des ersten Schalters und der Ausgang des zweiten Schalters mit einem anderen Eingang des ersten Schalters verbunden ist, und das am Ausgang des ersten Schalters anliegende Ausgangssignal dem elektromechanischen Element und dem Eingang des Komparators zugeführt ist, wobei der Ausgang des Komparators mit einem Steuereingang des ersten Schalters verbunden ist, um abhängig vom Niveau des Ausgangssignals zu steuern, ob das Signal des zweiten Schalters am Ausgang des ersten Schalters anliegt.

Es zeigen:
Figur 1: Prinzipielle Regelungsstruktur betreffend einen Piezo-Trägheitsantrieb nach dem Stand der Technik
Figur 2: Detaildarstellung der Treiberschnittstelle und des Treibers mit den entsprechenden Signalflüssen nach dem Stand der Technik gemäß der Regelungsstruktur von Figur 1
Figur 3: Schematische Darstellung der an einem elektromechanischem Element anliegenden Spannungspulse zum Anfahren einer Zielposition eines anzutreibenden Elements nach dem Stand der Technik
Figur 4: Detaildarstellung der Treiberschnittstelle und des Treibers einer erfindungsgemäßen Vorrichtung
Figur 5: Schematische Darstellung der an einem elektromechanischem Element anliegenden Spannungspulse zum Anfahren einer Zielposition eines anzutreibenden Elements nach dem erfindungsgemäßen Verfahren
Figur 6: Messwert-Diagramm zur vergleichenden Darstellung der Position-Zeit-Abhängigkeit zwischen einem bekannten Ansteuerverfahren und dem erfindungsgemäßen Ansteuerverfahren für einen Piezo-Trägheitsantrieb bei einem Vortrieb von 1 µm in einer ersten Richtung (Vorwärtsrichtung)
Figur 7: Messwert-Diagramm zur vergleichenden Darstellung der Position-Zeit-Abhängigkeit zwischen einem bekannten Ansteuerverfahren und dem erfindungsgemäßen Ansteuerverfahren für einen Piezo-Trägheitsantrieb bei einem Vortrieb von 1 µm in einer zweiten Richtung (Rückwärtsrichtung)
Figur 8: Messwert-Diagramm zur vergleichenden Darstellung des dynamischen Verhaltens eines Piezo-Trägheitsantriebs nach einer Schrittansteuerung gemäß dem bekannten und gemäß dem erfindungsgemäßen Ansteuerverfahren
Figur 9: Messwert-Diagramm zur Darstellung der Position-Zeit-Abhängigkeit bei dem erfindungsgemäßen Ansteuerverfahren für einen Piezo-Trägheitsantrieb bei unterschiedlichen Geschwindigkeiten zur Erreichung der Zielposition
Figur 10: Diagramm zur Darstellung der Geschwindigkeit eines anzutreibenden Elements über der Zeit unter Anwendung des erfindungsgemäßen Ansteuerverfahrens

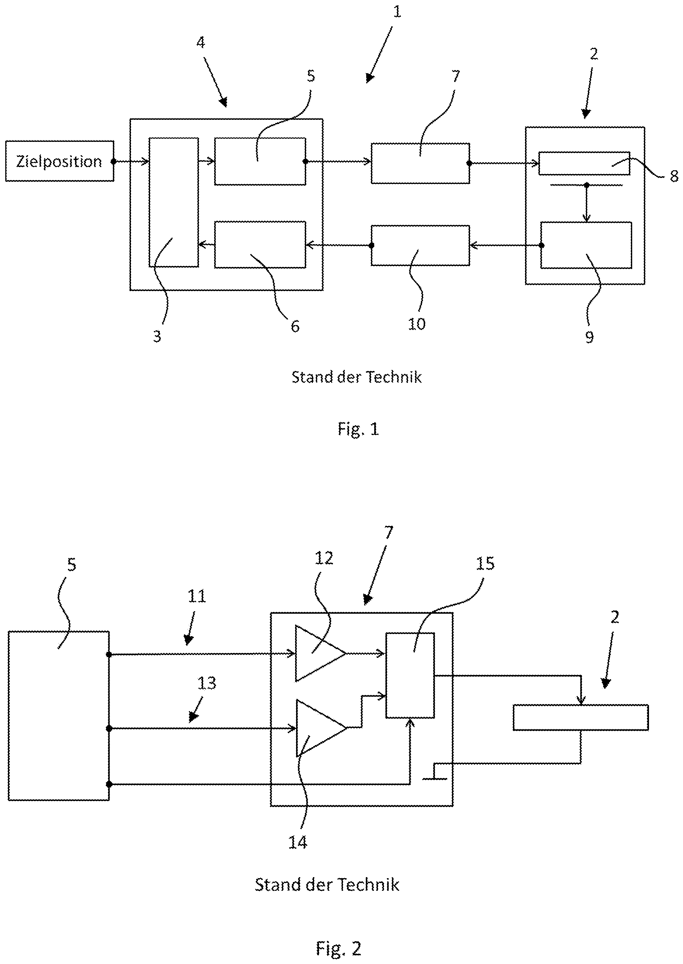

Figur 1 zeigt in genereller Weise eine bei der Anmelderin bisher eingesetzte und daher dem Stand der Technik zurechenbare Regelungsstruktur 1 für einen Piezo-Trägheitsantrieb 2. Hierbei wird die Zielposition des Antriebs einer Servoeinheit 3 eines Reglers 4 übergeben, welche ihrerseits mit einer Treiberschnittstelle 5 des Reglers 4 verbunden ist. Weiterhin weist der Regler 4 eine Sensorschnittstelle 6 auf. Die Treiberschnittstelle 5 übergibt an den Treiber 7 ein der Zielposition entsprechendes Signal, und der Treiber 7, der mit einem elektromechanischen Element 8 in Form eines Piezoaktuators des Piezo-Trägheitsantriebs 2 elektrisch verbunden ist, beaufschlagt das elektromechanische Element 8 mit einer dem elektrischen Signal entsprechenden Ladungsmenge, so dass dieses eine gewünschte zeitveränderliche Ausdehnung oder Kontraktion vollführt. Ein dem Trägheitsantrieb 2 zugeordneter Positionssensor 9 erfasst dessen Position, und ein entsprechendes Signal wird nach Aufbereitung durch eine Sensorverarbeitungseinheit 10 an die Sensorschnittstelle 6 des Reglers 4 übergeben und dort der Servoeinheit 3 zugeführt, so dass - abhängig von der momentanen Lage (d.h. der Ist-Position) des Trägheitsantriebs 2 im Vergleich zur Ziel- oder Soll-Position - die Servoeinheit 3 entweder weiterhin über die Treiberschnittstelle 5 dem Treiber 7 elektrische Signale zuführt, um das elektromechanische Element 8 pro Antriebsschritt mit entsprechenden Ladungsmengen zu beaufschlagen, oder aber nach Erreichen der Zielposition mit einer vorgegebenen Genauigkeit keine weiteren elektrischen Signale mehr an den Treiber 7 übergeben werden.

Figur 2 zeigt im Detail die Verbindung zwischen der Treiberschnittstelle 5 und dem Treiber 7 der Regelungsstruktur gemäß Figur 1. Die Treiberschnittstelle 5 übergibt zum Einen zwei elektrische Signale 11, nämlich ein Pulssignal und ein Richtungssignal, an den Schritttreiber 12 des Treibers 7, und zum Anderen ein elektrisches Signal 13, nämlich ein analoges Spannungssignal, an den Spannungstreiber 14 des Treibers 7. Der Schritttreiber 12 und der Spannungstreiber 14 übergeben die durch sie aufbereiteten elektrischen Signale den entsprechenden Eingängen eines Schalters 15. Gleichzeitig besteht eine Verbindung zwischen der Treiberschnittstelle 5 und dem Schalter 15 des Treibers 7, wodurch die Treiberschnittstelle 5 abhängig von den entsprechenden Positionsdaten des Trägheitsantriebs durch entsprechende elektrische Signale Einfluss auf den Antriebsmodus des Trägheitsantriebs nehmen kann bzw. ein Wechsel des Antriebsmodus' des Trägheitsantriebs bewerkstelligen kann. Über den Ausgang des Schalters 15 wird dem in Figur 2 nicht gezeigten elektromechanischen Element des Trägheitsantriebs 2 dann das entsprechende Spannungssignal zugeführt, so dass dieses eine gewünschte zeitveränderliche Ausdehnung oder Kontraktion vollführt.

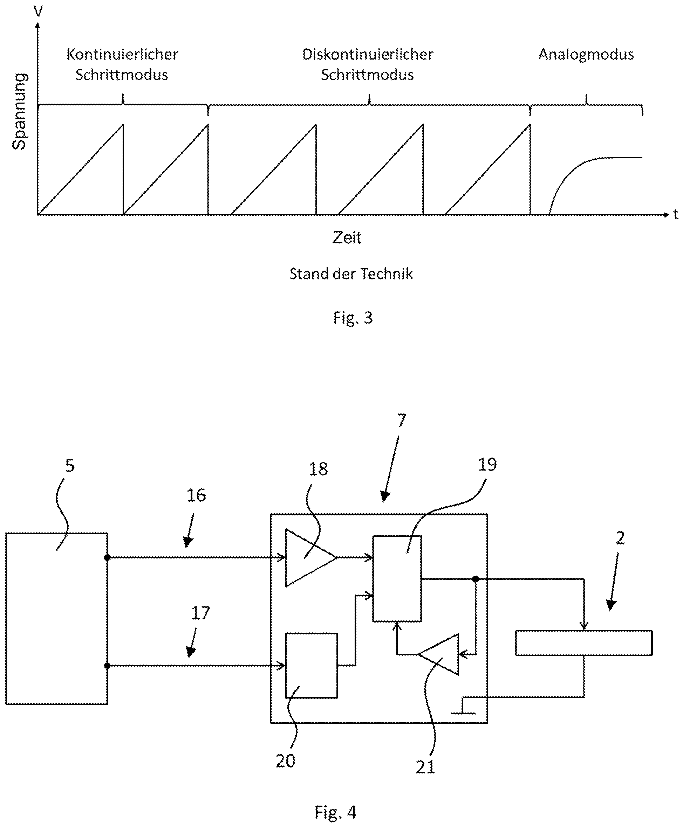

Figur 3 zeigt schematisch den zeitlichen Verlauf der einzelnen Spannungspulse, die an dem Piezoaktuator, welcher nach dem vorstehend beschriebenen und aus dem Stand der Technik bekannten Verfahren angesteuert wird, anliegen. Die einzelnen Spannungspulse haben dabei eine identische Rampenform mit einer flacheren, ansteigenden Flanke und einer steilen, abfallenden Flanke. Solange das anzutreibende Element weit von der Soll- oder Zielposition entfernt ist, liegen die Spannungspulse derart an, dass diese zeitlich ohne eine Unterbrechung aufeinanderfolgen. Es handelt sich hierbei um den kontinuierlichen Schrittmodus (siehe die beiden ersten Spannungspulse im Spannungs-Zeit-Diagramm von Fig. 3). Erkennt der Regler aufgrund der Signale des Positionssensors, dass das anzutreibende Element eine Position erreicht hat, die innerhalb eines definierten Wertefensters um die Zielposition herum liegt, so veranlasst der Regler ein Umschalten auf den diskontinuierlichen Modus, bei welchem zwischen aufeinanderfolgenden Spannungspulsen - welche die gleiche Form aufweisen wie innerhalb des kontinuierlichen Schrittmodus' - ein zeitlicher Abstand besteht. Sobald das anzutreibende Element eine Position erreicht hat, deren Differenz zur Zielposition innerhalb des Deformationsbereichs des Piezoaktuators liegt, schaltet der Regler erneut um, und zwar auf den Analogmodus, bei welchem das anzutreibende Element der Ausdehnung bzw. Deformation des Piezoaktuators analog folgt. Der Piezoaktuator wird durch entsprechende Ladungsbeaufschlagung nur noch so weit ausgelenkt, bis das anzutreibende Element die Zielposition erreicht hat.

Der Treiberschnittstelle 5 des Reglers 4 müssen zur Realisierung einer genauen und verlässlichen Regelung des Trägheitsantriebs eine Vielzahl von Informationen bereitgestellt werden. Diese umfassen neben der Differenz zwischen der Ist-Position und der Soll-Position des anzutreibenden Elements des Trägheitsantriebs die Schrittweite eines Einzelschritts, die Frequenz eines festgelegten Antriebsschrittes, die maximale elektrische Spannung, die an dem Piezoelement 8 anliegen darf, der lineare Verfahrbereich des Trägheitsantriebs, die Resonanzfrequenz des Trägheitsantrieb und dessen Dämpfungsverhalten sowie die Festlegung eines Positionsfensters für die Auswahl des Antriebsmodus'. Dem Treiber 7 muss die Frequenz eines festgelegten Antriebsschrittes und die maximale elektrische Spannung, die an dem Piezoelement 8 anliegen darf, als Information zur Verfügung gestellt werden.

Figur 4 zeigt im Detail die Verbindung zwischen der Treiberschnittstelle 5 und dem Treiber 7 der Regelungsstruktur gemäß Figur 1 einer erfindungsgemäßen Vorrichtung, die für ein erfindungsgemäßes Ansteuerverfahren geeignet ist. Die Treiberschnittstelle 5 ist derart eingerichtet, dass sie ein elektrisches Signal 16, welches ein analoges Stromsignal ist, an den Stromtreiber 18 übergibt. Weiterhin übergibt die Treiberschnittstelle 5 ein elektrisches Signal 17, bei dem es sich um ein Richtungssignal handelt, an den zweiten Schalter 20 des Treibers 7. Der Ausgang des Stromtreibers 18 und der Ausgang des zweiten Schalters 20 sind mit entsprechenden Eingängen des ersten Schalters 19 verbunden, und über den Ausgang des ersten Schalters 19 wird ein definierter Ladestrom bzw. eine definierte Ladungsmenge dem Piezoaktor des Trägheitsantriebs 2 und dem Eingang eines Komparators 21 zugeführt, wobei der Ausgang des Komparators 21 mit einem Steuereingang des ersten Schalters 19 verbunden ist.

Der Komparator 21 nimmt über seinen Eingang das aktuelle elektrische Spannungsniveau des Ausgangs des ersten Schalters 19 auf und steuert über seinen Ausgang abhängig von dem aktuellen Spannungsniveau den ersten Schalter 19 dergestalt, dass das Signal des zweiten Schalters 20 am Ausgang des ersten Schalters 19 anliegt oder nicht. Abhängig von der jeweils gewünschten Antriebsrichtung führt der Ausgang des zweiten Schalters 20 entweder das maximal mögliche positive oder das maximal mögliche negative spezifische Spannungsniveau für den Piezoaktor. Liegt das aktuelle Spannungsniveau nahe dem maximal möglichen positiven oder negativen Spannungsniveau des Piezoaktors, so wird über den Komparator 21 das ausgewählte Signal vom zweiten Schalter 20 an den Ausgang des ersten Schalters 19 gelegt, sodass eine zeitlich sehr schnell veränderliche Spannungsrampe entsteht. Der Begriff "nahe" im Sinne des Vorstehenden bedeutet, dass das aktuelle Spannungsniveau eine maximale Abweichung von 20% von dem maximal möglichen positiven bzw. maximal möglichen negativen Spannungsniveau des Piezoaktors aufweist.

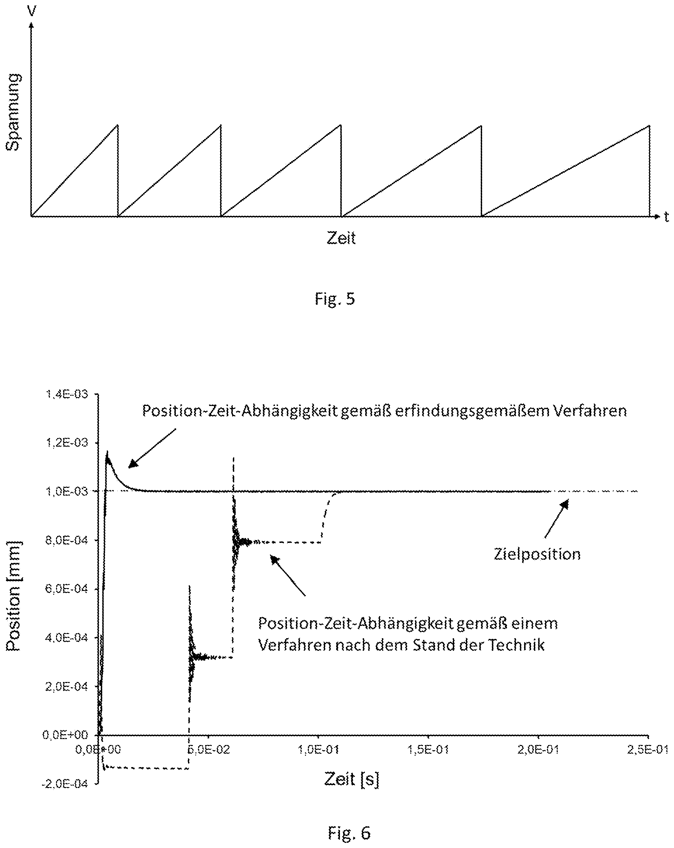

Figur 5 zeigt schematisch den zeitlichen Verlauf der einzelnen Spannungspulse, die an einem Piezoaktuator, welcher nach dem erfindungsgemäßen Verfahren angesteuert wird, anliegen. Im Gegensatz zu dem nach dem Stand der Technik bekannten Verfahren folgen die einzelnen Spannungspulse ohne zeitliche Unterbrechung bzw. mit einer sehr geringfügigen und vernachlässigbaren zeitlichen Differenz aufeinander. Zudem unterscheiden sich die aufeinander folgenden Spannungspulse in der Form, wobei bei jedem nachfolgenden Spannungspuls die Steigung der flacheren Flanke kontinuierlich abnimmt, so dass die Pulsdauer - bei gleichbleibender Maximalspannung jedes Spannungspulses - stetig größer wird.

Bei dem erfindungsgemäßen Ansteuerverfahren müssen der Treiberschnittstelle 5 des Reglers 4 zur Realisierung einer genauen und verlässlichen Regelung des Trägheitsantriebs lediglich aktorspezifische Informationen bereitgestellt werden, und der Treiber benötigt nur die Information bezüglich der maximalen Spannung, die auf das Piezoelement des Trägheitsantriebs aufgebracht werden bzw. an diesem anliegen darf. Somit ist die Realisierung wesentlich einfacher zu gestalten als bei dem aus dem Stand der Technik bekannten Ansteuerverfahren. Darüber hinaus resultiert gegenüber dem Stand der Technik eine kontinuierliche lineare Stromausgabe der Servoeinheit und des Treibers ohne Unstetigkeiten aufgrund von Modenwechseln bzw.. Überwachungszeitabschnitten, d.h. Zeitabschnitten zur Überwachen einer Ausschwingzeit des Trägheitsantriebs. Insgesamt resultiert ein wesentlich lineareres Verhalten des Trägheitsantriebs.

Figur 6 ist ein Messwert-Diagramm zur vergleichenden Darstellung der Position-Zeit-Abhängigkeit zwischen einem bekannten Ansteuerverfahren und dem erfindungsgemäßen Ansteuerverfahren für einen Piezo-Trägheitsantrieb. Es ist deutlich zu erkennen, dass nach dem erfindungsgemäßen Verfahren die Zielposition des anzutreibenden Elements des Trägheitsantriebs wesentlich schneller erreicht wird. Das liegt insbesondere daran, dass zwischen den einzelnen Antriebsschritten nur äußerst geringe bzw. vernachlässigbare zeitliche Differenzen bestehen, während beim Ansteuerverfahren nach dem Stand der Technik relativ lange nach einem einzelnen Antriebsschritt gewartet werden muss, bis das mechanische System des Trägheitsantriebs einen ausgeschwungenen Zustand erreicht hat, und erst danach entscheiden werden kann, mit welchem Modus der Trägheitsantrieb in einem nachfolgenden Schritt angesteuert werden soll.

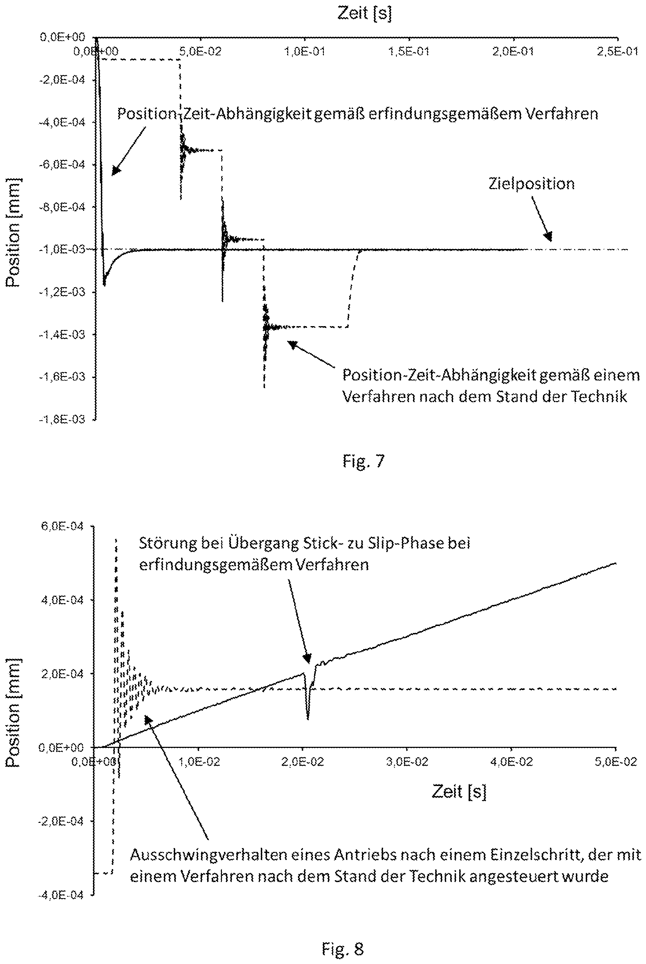

Figur 7 zeigt ebenfalls ein Messwert-Diagramm zur vergleichenden Darstellung der Position-Zeit-Abhängigkeit zwischen einem bekannten Ansteuerverfahren und dem erfindungsgemäßen Ansteuerverfahren für einen Piezo-Trägheitsantrieb, hier jedoch für einen Antriebsschritt in einer RückwärtsRichtung nach einem vorausgehenden Vorwärts-Schritt. Abermals ist zu erkennen, dass die Zielposition des anzutreibenden Elements des Trägheitsantriebs nach dem erfindungsgemäßen Ansteuerverfahren erheblich schneller erreicht wird als nach dem Ansteuerverfahren gemäß dem Stand der Technik.

Figur 8 zeigt ein weiteres Messwert-Diagramm, welches zum Einen das Verhalten eines Trägheitsantriebs nach einer Schrittansteuerung gemäß dem aus dem Stand der Technik bekannten Ansteuerverfahrens aufzeigt. Hierbei ist deutlich zu erkennen, dass nach der pulsartigen Antriebsbewegung das System des Trägheitsantriebs zu nachteiligen Schwingungen angeregt wird, welche eine relativ lange Ausschwingzeit benötigen, wobei erst nach dem Ausschwingen eine hochgenaue Bestimmung der aktuellen Position des anzutreibenden Elements möglich ist. Das bedeutet, dass nach einem solchen Einzelschritt der nächste Einzelschritt erst nach Abwarten des Ausschwingens gestartet werden kann, woraus ein vergleichsweise langsames und wenig dynamisches Ansteuerverfahren resultiert.

Zum Anderen zeigt das Messwert-Diagramm von Figur 8 eine Position-Zeit-Kurve des anzutreibenden Elements eines Trägheitsantriebs, der nach dem erfindungsgemäßen Verfahren angesteuert wurde. Zum Zeitpunkt des Wechsels von dem Antriebszeitabschnitt zu dem Relativbewegungszeitabschnitt ist nur eine geringfügige Störung in der Position-Zeit-Kurve zu erkennen, und es kommt dabei nicht zu dem aus dem Stand der Technik bekannten und nachteiligen Aufschwingen des Antriebsystems. Nach einem Einzelschritt kann daher zu jeder Phase des Anfahrens der Zielposition direkt mit einem nachfolgenden Einzelschritt gestartet werden, woraus ein sehr schnelles und hochdynamisches Ansteuerverfahren und ein entsprechender Trägheitsantrieb resultieren.

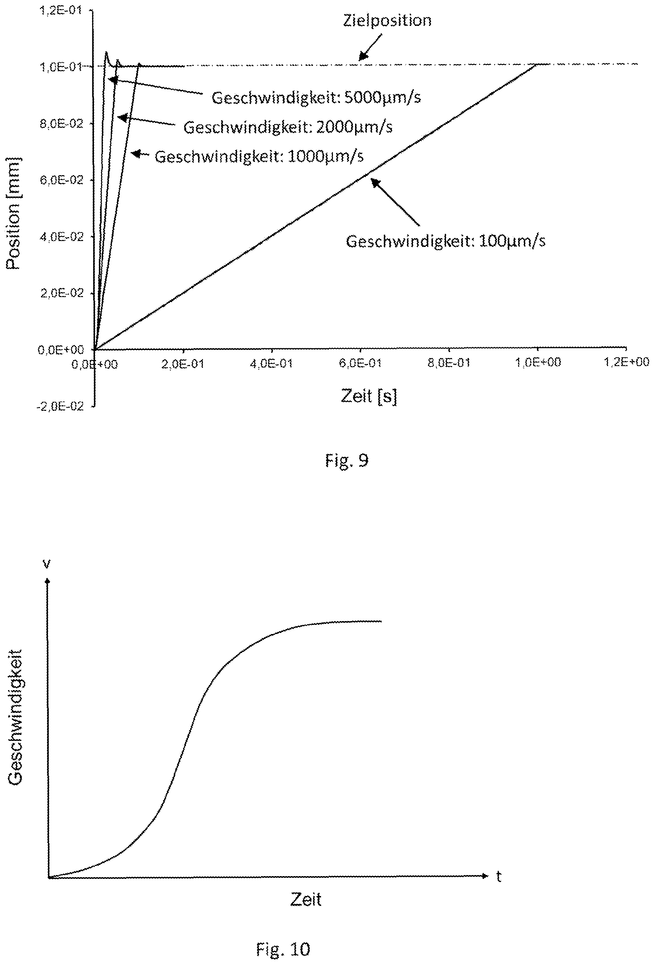

Figur 9 verdeutlicht in einem weiteren Messwert-Diagramm, bei welchem die Position des anzutreibenden Elements eines Piezo-Trägheitsantriebs über der Zeit dargestellt ist, die verbesserten Möglichkeiten des erfindungsgemäßen Ansteuerverfahrens. Beim entsprechend angesteuerten Trägheitsantrieb kann das anzutreibende Element hochdynamisch und quasi linear mit unterschiedlichen Geschwindigkeiten an eine Zielposition verfahren werden.

Mit dem erfindungsgemäßen Ansteuerverfahren ist es zudem auf vergleichsweise einfach Art möglich, die Zielposition des anzutreibenden Elements entlang einer nicht-linearen Positionierungskurve mit pro Zeiteinheit voneinander abweichenden Antriebsschrittweiten anzufahren. Gemäß Figur 10 kann das anzutreibende Element zu Beginn der Positionierung mit geringerer Antriebsgeschwindigkeit bewegt werden, um in der Folge die Antriebsgeschwindigkeit stetig bis zur maximalen Antriebsgeschwindigkeit zu erhöhen, um kurv vor Erreichen der Zielposition die Antriebsgeschwindigkeit des anzutreibenden Elements kontinuierlich abzusenken, und damit eine Geschwindigkeits-Zeit-Kurve mit einer S-Form resultiert. Somit ist das erfindungsgemäße Ansteuerverfahren bzw. die entsprechende Vorrichtung auch für dynamische Anwendungen geeignet, für welche bisher andere Antriebskonzepte Verwendung fanden.

## Patentansprüche

1. Ansteuerverfahren für ein elektromechanisches Element (8) zur Positionierung eines zumindest zeitweise mit dem elektromechanischen Element in Kontakt stehenden anzutreibenden Elements, wobei in einem Schrittmodus an dem elektromechanischen Element (8) elektrische Spannungspulse anliegen und jeder Spannungspuls wenigstens zwei Zeitabschnitte aufweist, wobei in einem der Zeitabschnitte eine durchschnittlich langsamere zeitliche Änderung der elektrischen Spannung und in dem anderen Zeitabschnitt eine durchschnittlich schnellere zeitliche Änderung der elektrischen Spannung stattfindet, und zumindest in einem Teil des Zeitabschnitts der durchschnittlich langsameren zeitlichen Änderung der elektrischen Spannung, welcher einen Antriebszeitabschnitt definiert, durch Haftreibung zwischen dem sich in Antriebsrichtung expandierenden oder kontrahierenden elektromechanischen Element (8) und dem anzutreibenden Element dieses von dem elektromechanischen Element (8) mitbewegt wird, und zumindest in einem Teil des Zeitabschnitts der durchschnittlich schnelleren zeitlichen Änderung der elektrischen Spannung, welcher einen Relativbewegungszeitabschnitt definiert, durch Gleitreibung zwischen dem sich entgegengesetzt zur Antriebsrichtung kontrahierenden oder expandierenden elektromechanischen Element (8) und dem anzutreibenden Element eine Relativbewegung zwischen elektromechanischem Element (8) und anzutreibendem Element stattfindet, so dass das anzutreibende Element mit jedem Spannungspuls einen diskreten Schritt in Antriebsrichtung ausführt, und das Verfahren weiterhin das Vorsehen eines Reglers (4) und eines damit elektrisch verbundenen Treibers (7) umfasst, **dadurch gekennzeichnet, dass** der Regler (4) einen zeitkontinuierlichen Strom (16, 17) an den Treiber (7) übergibt, und der Treiber (7) einen entsprechenden Ladestrom an das mit diesem elektrisch verbundene elektromechanische Element (8) ausgibt, wobei der Regler den zeitkontinuierlichen Strom (16, 17) abhängig von der Differenz zwischen der Ist-Position und der Zielposition des anzutreibenden Elements stetig anpasst, und der Treiber (7) unabhängig vom Regler (4) und abhängig von der am elektromechanischen Element (8) anliegenden Spannung eine elektrische Trennung des Treibers (7) von dem Regler (4) vornimmt.

2. Verfahren nach Anspruch 1, **dadurch gekennzeichnet, dass** der Regler (4) dem Treiber (7) ein digitales Signal (17) übergibt, welches bestimmt, ob in dem Antriebszeitabschnitt der Betrag der an dem elektromechanischen Element anliegenden elektrischen Spannung mit zunehmender Zeitdauer zunimmt oder abnimmt.

3. Verfahren nach Anspruch 1 oder 2, **dadurch gekennzeichnet, dass** sich an den Schrittmodus ein Analogmodus anschließt, bei welchem das elektromechanische Element (8) mit einer zeitveränderlichen stetigen elektrischen Spannung beaufschlagt wird, so dass das elektromechanische Element (8) dem Spannungssignal linear folgt und das anzutreibende Element eine entsprechende kontinuierliche und analoge Bewegung ausführt.

4. Verfahren nach einem der vorhergehenden Ansprüche, **dadurch gekennzeichnet, dass** der vom Regler (4) an den Treiber (7) übergebene zeitkontinuierliche Strom dergestalt ist, dass die Geschwindigkeit des anzutreibenden Elements zwischen dessen Ist-Position und dessen Zielposition eine definierte zeitliche Abhängigkeit aufweist mit einer entsprechenden Geschwindigkeits-Zeit-Kurve.

5. Verfahren nach Anspruch 4, **dadurch gekennzeichnet, dass** die Geschwindigkeits-Zeit-Kurve eine S-Form aufweist.

6. Vorrichtung (1) zur elektrischen Ansteuerung eines elektromechanischen Elements (8) zur Positionierung eines zumindest zeitweise mit dem elektromechanischen Element (8) in Kontakt stehenden anzutreibenden Elements, wobei die Vorrichtung (1) einen Regler (4) und einen mit diesem elektrisch verbundenen Treiber (7) aufweist, derart konfiguriert, dass in einem Schrittmodus das elektromechanische Element (8) mit direkt aufeinanderfolgenden elektrischen Spannungspulsen beaufschlagt wird, wobei jeder Spannungspuls wenigstens zwei Zeitabschnitte aufweist, und in einem der Zeitabschnitte durchschnittlich eine langsamere zeitliche Änderung der elektrischen Spannung und in dem anderen Zeitabschnitt durchschnittlich eine schnellere zeitliche Änderung der elektrischen Spannung stattfindet, und zumindest in einem Teil des Zeitabschnitts der durchschnittlich langsameren zeitlichen Änderung der elektrischen Spannung, welcher einen Antriebszeitabschnitt definiert, durch Haftreibung zwischen dem sich in Antriebsrichtung expandierenden oder kontrahierenden elektromechanischen Element (8) und dem anzutreibenden Element dieses von dem elektromechanischen Element (8) mitbewegt wird, und zumindest in einem Teil des Zeitabschnitts der durchschnittlich schnelleren zeitlichen Änderung der elektrischen Spannung, welcher einen Relativbewegungszeitabschnitt definiert, durch Gleitreibung zwischen dem sich entgegengesetzt zur Antriebsrichtung kontrahierenden oder expandierenden elektromechanischen Element (8) und dem anzutreibenden Element eine Relativbewegung zwischen elektromechanischem Element (8) und anzutreibendem Element stattfindet, so dass das anzutreibende Element mit jedem Spannungspuls einen diskreten Schritt in Antriebsrichtung ausführt, **dadurch gekennzeichnet, dass** der Regler (4) derart konfiguriert ist, dass er über eine Treiberschnittstelle (5) einen zeitkontinuierlichen Strom an den Treiber (7) übergibt und dass der Treiber (7) derart konfiguriert ist, dass er einen entsprechenden Ladestrom an das mit diesem elektrisch verbundene elektromechanische Element (8) ausgibt, und dass der Regler (4) abhängig von der Differenz zwischen der Ist-Position und der Zielposition des anzutreibenden Elements den zeitkontinuierlichen Strom anpasst, und, dass der Treiber (7) unabhängig vom Regler (4) und abhängig von der am elektromechanischen Element (8) anliegenden Spannung eine elektrische Trennung des Treibers (7) von dem Regler (4) vornimmt.

7. Vorrichtung nach Anspruch 6, **dadurch gekennzeichnet, dass** der Treiber (7) einen Stromtreiber (18), einen ersten Schalter (19), einen zweiten Schalter (20) und einen Komparator (21) aufweist, wobei der Ausgang des Stromtreibers (18) mit einem Eingang des ersten Schalters (19) und der Ausgang des zweiten Schalters (20) mit einem anderen Eingang des ersten Schalters (19) verbunden ist, und das am Ausgang des ersten Schalters (19) anliegende Ausgangssignal dem elektromechanischen Element (8) und dem Eingang des Komparators (21) zugeführt ist, wobei der Ausgang des Komparators (21) mit einem Steuereingang des ersten Schalters (19) verbunden ist, um abhängig vom Niveau des Ausgangssignals zu steuern, ob das Signal des zweiten Schalters (20) am Ausgang des ersten Schalters anliegt.

## Claims

1. Control method for an electromechanical element (8) for positioning an element to be driven which is at least intermittently in contact with the electromechanical element, wherein in a step mode electrical voltage pulses are applied to the electromechanical element (8) and each voltage pulse comprises at least two periods of time, wherein in one of the periods of time an on average slower time change of the electrical voltage and in the other period of time an on average faster time change of the electrical voltage takes place, and wherein at least in a part of the period of time of the on average slower time change of the electrical voltage, which defines a drive period, by static friction between the electromechanical element (8) expanding or contracting in the driving direction and the driven element, the same is moved by and together with the electromechanical element (8), and wherein at least in a part of the period of time of the on average faster time change of the electrical voltage, which defines a relative movement period, by sliding friction between the electromechanical element (8) contracting or expanding in a direction opposite to the drive direction and the element to be driven, a relative movement between electromechanical element (8) and element to be driven takes place so that the element to be driven carries out a discrete step in the drive direction with each voltage pulse, and wherein the method further comprises the provision of a controller (4) and a driver (7) electrically connected thereto, **characterized in that** the controller (4) transmits a continuous-time current (16, 17) to the driver (7), and the driver (7) outputs a corresponding charging current to the electromechanical element (8) electrically connected thereto, wherein the controller continuously adjusts the continuous-time current (16, 17) depending on the difference between the actual position and the target position of the element to be driven, and wherein the driver (7) independently of the controller (4) and depending on the voltage applied to the electromechanical element (8) provides an electrical separation of the driver (7) from the controller (4).

2. Method according to claim 1, **characterized in that** the controller (4) transmits to the driver (7) a digital signal (17) which determines whether, in the drive period, the amount of electric voltage applied to the electromechanical element increases or decreases with increasing duration.

3. Method according to claim 1 or 2, **characterized in that** the step mode is followed by an analog mode in which the electromechanical element (8) is subjected to a time-varying continuous electric voltage such that the electromechanical element (8) follows the voltage signal linearly and the element to be driven carries out a corresponding continuous and analogue movement.

4. Method according to one of the preceding claims, **characterized in that** the time-continuous current transferred from the controller (4) to the driver (7) is such that the speed of the element to be driven comprises a defined time dependence between its actual position and its target position with a corresponding speed-time curve.

5. Method according to claim 4, **characterized in that** the speed-time curve has a S-shape.

6. Device (1) for electrically actuating an electromechanical element (8) for positioning an element to be driven which is in contact at least intermittently with the electromechanical element (8), the device (1) comprising a controller (4) and a driver (4) electrically connected thereto, configured such that, in a step mode, the electromechanical element (8) is subjected to directly successive electrical voltage pulses, wherein each voltage pulse comprises at least two periods of time, and wherein in one of the periods of time an on average slower time change of the electrical voltage and in the other period of time an on average faster time change of the electrical voltage takes place, and wherein at least in a part of the period of time of the on average slower time change of the electrical voltage, which defines a drive period, by static friction between the electromechanical element (8) expanding or contracting in the driving direction and the driven element, the same is moved by and together with the electromechanical element (8), and wherein at least in a part of the period of time of the on average faster time change of the electrical voltage, which defines a relative movement period, by sliding friction between the electromechanical element (8) contracting or expanding in a direction opposite to the drive direction and the element to be driven, a relative movement between electromechanical element (8) and element to be driven takes place so that the element to be driven carries out a discrete step in the drive direction with each voltage pulse, and wherein the method further comprises the provision of a controller (4) and a driver (7) electrically connected thereto, **characterized in that** the controller (4) is configured such that the same transmits a continuous-time current (16, 17) to the driver (7), and **in that** the driver (7) is configured such that the same outputs a corresponding charging current to the electromechanical element (8) electrically connected thereto, and **in that** the controller (4) adjusts the continuous-time current (16, 17) depending on the difference between the actual position and the target position of the element to be driven, and **in that** the driver (7) independently of the controller (4) and depending on the voltage applied to the electromechanical element (8) provides an electrical separation of the driver (7) from the controller (4).

7. Device according to claim 6, **characterized in that** the driver (7) comprises a current driver (18), a first switch (19), a second switch (20) and a comparator (21), the output of the current driver (18) being connected to an input of the first switch (19) and the output of the second switch (20) being connected to another input of the first switch (19), and **in that** the output signal at the output of the first switch (19) is fed to the electromechanical element (8) and the input of the comparator (21), wherein the output of the comparator (21) is connected to a control input of the first switch (19) to control, depending on the level of the output signal, whether the signal of the second switch (20) is applied to the output of the first switch.

## Revendications

1. Procédé de commande d'un élément électromécanique (8) pour le positionnement d'un élément à entraîner au moins périodiquement en contact avec l'élément électromécanique, dans lequel, en mode pas à pas, des impulsions de tension électrique sont appliquées à l'élément électromécanique (8) et chaque impulsion de tension présente au moins deux laps temporels, sachant que, dans une des laps temporels, une modification temporelle en moyenne plus lente de la tension électrique et, dans l'autre laps temporel, une modification temporelle en moyenne plus rapide de la tension électrique a lieu, et, au moins dans une partie du laps temporel de la modification en moyenne plus lente de la tension électrique qui définit un laps temporel d'entraînement, par frottement d'adhérence entre l'élément électromécanique (8) se dilatant ou se contractant dans le sens d'entraînement et l'élément à entraîner, celui-ci est déplacé conjointement par cet élément électromécanique (8), et, au moins dans une partie du laps temporel de la modification temporelle en moyenne plus rapide de la tension électrique qui définit un laps temporel de mouvement relatif, par frottement d'adhérence entre l'élément électromécanique (8) se contractant ou se dilatant dans le sens inverse au sens d'entraînement et l'élément à entraîner, un mouvement relatif entre l'élément électromécanique (8) et l'élément à entraîner a lieu, de sorte que l'élément à entraîner exécute à chaque impulsion de tension un pas discret dans le sens d'entraînement, et le procédé comprend en outre la prévision d'un régleur (4) et d'un pilote qui lui est connecté électriquement (7), **caractérisé en ce que** le régleur (4) transmet un courant continu dans le temps (16, 17) au pilote (7) et que le pilote (7) envoie un courant de charge correspondant à l'élément électromécanique (8) qui lui est relié électriquement, le régleur (16, 17) adaptant en permanence le courant continu dans le temps (7) en fonction de la différence entre la position réelle et la position de destination de l'élément à entraîner et que le pilote (7), indépendamment du régleur (4) et en fonction de la tension appliquée à l'élément électromécanique (8), procède à une séparation électrique du pilote (7) et du régleur (4).

2. Procédé selon la revendication 1, **caractérisé en ce que** le régleur (4) transmet au pilote (7) un signal numérique (17) qui définit si, dans le laps temporel d'entraînement, le montant de la tension électrique appliquée à l'élément trop mécanique augmente ou diminue au fur et à mesure de l'augmentation de la durée temporelle.

3. Procédé selon la revendication 1 ou 2, **caractérisé en ce que** le mode pas à pas est suivi d'un mode analogique dans lequel l'élément électromécanique (8) est sollicité avec une tension électrique constante variable dans le temps, de sorte que l'élément électromécanique (8) suit linéairement le signal de tension et que l'élément à entraîner exécute un mouvement continu et analogique correspondant.

4. Procédé selon une des revendications précédentes, **caractérisé en ce que** le courant continu dans le temps transmis du régleur (4) au pilote (7) est tel que la vitesse de l'élément à entraîner présente, entre sa position réelle et sa position de destination, une dépendance temporelle définie avec une courbe vitesse-temps correspondante.

5. Procédé selon la revendication 4, **caractérisé en ce que** la courbe vitesse-temps présente une forme de S.

6. Dispositif (1) de commande électrique d'un élément électromécanique (8) pour le positionnement d'un élément à entraîner au moins périodiquement en contact avec l'élément électromécanique (8), dans lequel le dispositif (1) présente un régleur (4) et un pilote (7) qui lui est relié électriquement, est conçu de manière à ce que, en mode pas à pas, l'élément électromécanique (8) soit sollicité par des impulsions de tension électrique se succédant directement, chaque impulsion de tension présentant au moins deux laps temporels, sachant que, dans un des laps temporels, une modification temporelle en moyenne plus lente de la tension électrique et, dans l'autre laps temporel, une modification temporelle en moyenne plus rapide de la tension électrique a lieu, et, au moins dans une partie du laps temporel de la modification en moyenne plus lente de la tension électrique qui définit un laps temporel d'entraînement, par frottement d'adhérence entre l'élément électromécanique (8) se dilatant ou se contractant dans le sens d'entraînement et l'élément à entraîner, celui-ci est déplacé conjointement par cet élément électromécanique (8), et, au moins dans une partie du laps temporel de la modification temporelle en moyenne plus rapide de la tension électrique qui définit un laps temporel de mouvement relatif, par frottement d'adhérence entre l'élément électromécanique (8) se contractant ou se dilatant dans le sens inverse au sens d'entraînement et l'élément à entraîner, un mouvement relatif entre l'élément électromécanique (8) et l'élément à entraîner a lieu, de sorte que l'élément à entraîner exécute à chaque impulsion de tension un pas discret dans le sens d'entraînement, **caractérisé en ce que** le régleur (4) est conçu de manière à transmettre, par l'intermédiaire d'une interface de pilote (5), un courant continu dans le temps au pilote (7) et que le pilote (7) est conçu de manière à envoyer un courant de charge correspondant à l'élément électromécanique (8) qui lui est relié électriquement et que le régleur (4), en fonction de la différence entre la position réelle et la position de destination de l'élément à entraîner, adapte le courant continu dans le temps et que le pilote (7), indépendamment du régleur (4) et en fonction de la tension appliquée à l'élément électromécanique (8), procède à une séparation électrique du pilote (7) et du régleur (4).

7. Dispositif selon la revendication 6, **caractérisé en ce que** le pilote (7) présente un pilote de courant (18), un premier commutateur (19), un second commutateur (20) et un comparateur (21), la sortie du pilote de courant (18) étant raccordée à l'entrée du premier commutateur (19) et la sortie du second commutateur (20) à une autre entrée du premier commutateur (19) et que le signal de sortie appliqué à la sortie du premier commutateur (19) est communiqué à l'élément électromécanique (8) et à l'entrée du comparateur (21), la sortie du comparateur (21) étant raccordée à une entrée de commande du premier commutateur (19) afin de contrôler, en fonction du niveau du signal de sortie, si le signal du second commutateur (20) est appliqué à la sortie du premier commutateur.
